Europäisches Patentamt

European Patent Office

Office européen des brevets

(11) Veröffentlichungsnummer: **0 580 052 A2**

# (12) EUROPÄISCHE PATENTANMELDUNG

(21) Anmeldenummer: **93111118.1**

(51) Int. Cl.5: **G03F 7/11**, G03F 7/20

(22) Anmeldetag: **12.07.93**

(30) Priorität: **21.07.92 DE 4223888**

(43) Veröffentlichungstag der Anmeldung:
**26.01.94 Patentblatt 94/04**

(84) Benannte Vertragsstaaten:
**AT BE CH DE ES FR GB IT LI NL SE**

(71) Anmelder: **BASF Aktiengesellschaft
Carl-Bosch-Strasse 38
D-67063 Ludwigshafen(DE)**

(72) Erfinder: **Hoessel, peter, Dr.
Salierstrasse 71
D-6707 Schifferstadt(DE)**
Erfinder: **Hoffmann, Gerhard, Dr.
Pappelstrasse 22
D-6701 Otterstadt(DE)**

(54) **Verfahren zur Herstellung von Mikrostrukturkörpern.**

(57) Die Erfindung betrifft ein Verfahren zur Herstellung von Mikrostrukturkörpern mit Strukturtiefen von mehreren μm bis in den mm-Bereich durch bildmäßiges Bestrahlen von Polymeren mit Röntgenstrahlen und Entfernen der bildmäßig bestrahlten Bereiche der Polymeren, wobei die Polymeren vor dem bildmäßigen Bestrahlen in Schichtdicken von mehreren μm bis in den mm-Bereich durch Aufschmelzen unter Druck auf einen elektrisch leitfähigen Träger aufgebracht und fest verankert werden.

Das erfindungsgemäße Verfahren eignet sich insbesondere zur Herstellung von Mikrostrukturkörpern mit Strukturtiefen zwischen 3 μm und 2000 μm und lateralen Abmessungen von unter 10 μm.

EP 0 580 052 A2

Die Erfindung betrifft ein Verfahren zur Herstellung von Mikrostrukturkörpern mit Strukturtiefen von mehreren μm bis in den mm-Bereich durch bildmäßiges Bestrahlen von Polymeren mit Röntgenstrahlen und Entfernen der bildmäßig bestrahlten Bereiche der Polymeren, wobei diese Polymeren vor dem bildmäßigen Bestrahlen auf einem elektrisch leitfähigen Träger fest verankert werden.

Die Entwicklung der Mikroelektronik hat gezeigt, daß die konsequente Miniaturisierung und Integration zu einer unüberschaubaren Vielfalt neuer Produkte mit entsprechenden Technologien führt. Die Mikroelektronik hat in wenigen Jahren gegenüber anderen Industriezweigen einen gewaltigen Vorsprung in der Miniaturisierung gewonnen. Inzwischen zeichnet sich ab, daß in Zukunft auch andere Mikrotechniken eine große Bedeutung erlangen werden, wobei insbesondere die Mikromechanik und die integrierte Optik zu erwähnen sind. Solche Techniken eröffnen in der Kombination mit der Mikroelektronik eine unvorstellbare Zahl neuer elektronischer, optischer, biologischer und mechanischer Funktionselemente.

Bei einer Massenfertigung von nichtelektronischen Bauelementen, Systemkomponenten und Subsystemen der Mikrotechnik wird man naturgemäß die außerordentlich leistungsfähigen Fertigungsmethoden der Halbleitertechnik in möglichst großem Umfang nutzen. Gleichzeitig muß man versuchen, klassische Methoden der Feinwerktechnik für die Mikromechanik zu ertüchtigen und mit entsprechend modifizierten Halbleiterfertigungsmethoden zu verschmelzen, um so die engen Grenzen der Siliciumplanartechnik verlassen und neue Gestaltungsmöglichkeiten erschließen zu können, die auf einer Vielfalt von Formen und Materialien aufbauen. Diese Forderung wird z.B. in hohem Maße durch das LIGA-Verfahren erfüllt, das auf den Fertigungsschritten

- Lithographie,
- Galvanoformung und
- Abformung

aufgebaut und am Kernforschungszentrum Karlsruhe (KfK) entwickelt worden ist.

Interessante Mikrostrukturprodukte sind Sensoren zur Messung von Beschleunigung, Durchfluß, Ultraschall, Feuchte u.ä., Mikromotoren, mikropneumatische Bauelemente, Mikrostecker für die Mikroelektronik, mikrooptische Bauelemente, Faseroptiken, Mikroelektroden, Spinndüsen, Mikrofilter, Gleitlager, Membranen und vieles mehr.

Der wesentliche Fertigungsschritt des LIGA-Verfahrens ist die strukturgenaue Bestrahlung des eingesetzten Polymeren. Die prinzipielle Durchführbarkeit des LIGA-Verfahrens konnte anhand einfacher Mikrostrukturen mit einem speziell hergestellten Polymethylmethacrylat (im folgenden PMMA genannt) nachgewiesen werden.

Für die Herstellung komplexer dreidimensionaler Strukturen mit Strukturtiefen von mehreren μm bis in den mm-Bereich nach dem oben genannten LIGA-Verfahren, muß das PMMA auf eine leitfähige Trägerplatte aufgebracht werden. Bisher wird hierfür ein spezielles Gießverfahren verwendet. Hierbei wird in Methylmethacrylat gelöstes PMMA als Gießharz verwendet, und mit speziellen Initiatoren, Katalysatoren und Haftvermittlern in einem Rahmen in flüssiger Form auf die elektrisch leitfähige Trägerplatte aufgebracht und unter dem Einfluß von Licht oder Temperatur polymerisiert.

Durch die Verarbeitung eines Gießharzes ergeben sich die folgenden Probleme:

a) der durch die Polymerisation des Gießharzes auf der Trägerplatte erzeugte Polymerisationsschrumpf führt zu Spannungen im Laminat;

b) um diese Spannungen weitgehend zu vermeiden, müssen lange Temperprozesse bei der Polymerisation und Abkühlzeiten bis zu 24 Stunden in Kauf genommen werden;

c) die Auswahlmöglichkeit der Polymere ist beschränkt. Es können nur Polymere, welche als Gießharze oder in Form ihrer Monomere während des Laminierprozesses polymerisierbar sind, verwendet werden;

d) es können keine beliebigen, kommerziell erhältlichen Thermoplaste in beliebiger fester Form, z.B. als Granulat oder Pulver verwendet werden;

e) bislang werden nur PMMA nach dem oben beschriebenen Verfahren für das LIGA-Verfahren eingesetzt.

Bei der Herstellung komplexer dreidimensionaler Strukturen mit Strukturtiefen von mehreren μm bis in den mm-Bereich nach dem oben genannten LIGA-Verfahren hat sich gezeigt, daß PMMA einen hohen Bestrahlungsaufwand erfordert.

Weiter hat sich gezeigt, daß bei der Entwicklung der bestrahlten Polymeranteile mit einem geeigneten Entwicklermedium die unbestrahlten Polymeranteile quellen, wobei feine Mikrostrukturen zerstört werden können. Andererseits können gequollene Polymeranteile beim Austrocknen zu Spannungsrissen führen, die bei der Galvanik zu unbrauchbaren Mikrostrukturkörpern führen. Ursache für diese Probleme ist die hohe Lösungsmittelempfindlichkeit des PMMA.

Aufgabe der vorliegenden Erfindung ist es, ein Verfahren aufzuzeigen, das die Lösung der oben angeführten Probleme ermöglicht. Nach dem neuen Verfahren sollten beliebige Polymere, insbesondere solche, wie sie in den deutschen Patentanmeldungen DE-A-41 07 662, DE-A-41 07 851 und DE-A-41 41 352 beschrieben werden, zu einem dauerhaften Polymer/Träger-Verbundverarbeitet werden können. Eine weitere Aufgabe der vorliegenden Erfindung bestand darin, ein Verfahren zu entwickeln, das es erlaubt, diesen Polymer/Trägerverbund in möglichst kurzer Zeit, d.h. in wenigen Stunden oder gar in Minuten exakt und reproduzierbar herzustellen.

Überraschenderweise lassen sich diese Aufgaben durch ein Preßverfahren unter Verwendung eines Rahmens, der die Abmessungen der Polymerschicht vorgibt, lösen.

Gegenstand der vorliegenden Erfindung ist ein Verfahren zur Herstellung von Mikrostrukturkörpern mit Strukturtiefen von mehreren $\mu$m bis in den mm-Bereich durch bildmäßiges Bestrahlen von Polymeren mit Röntgenstrahlen und Entfernen der bildmäßig bestrahlten Bereiche der Polymeren, das dadurch gekennzeichnet ist, daß die Polymeren vor dem bildmäßigen Bestrahlen in Schichtdicken von mehreren $\mu$m bis in den mm-Bereich durch Aufschmelzen unter Druck auf einen elektrisch leitfähigen Träger aufgebracht und fest verankert werden.

Als Polymere für das erfindungsgemäße Verfahren können vorzugsweise sowohl amorphe Thermoplaste als auch teilkristalline Thermoplaste eingesetzt werden, die jeweils während des Preßverfahrens aufgeschmolzen werden.

Als Röntgenstrahlen zum bildmäßigen Bestrahlen wird vorzugsweise Synchrotronstrahlung eingesetzt.

Das erfindungsgemäße Verfahren eignet sich insbesondere zur Herstellung von Mikrostrukturkörpern mit Strukturtiefen zwischen 3 $\mu$m und 2000 $\mu$m und lateralen Abmessungen von unter 10 $\mu$m.

Bevorzugt ist auch eine Ausführungsform des erfindungsgemäßen Verfahrens zur Herstellung von Mikrostrukturkörpern, wobei vor dem Bestrahlen der Polymeren die Polymeren in einem Rahmen durch Aufschmelzen unter Druck auf den Träger laminiert werden.

Zum erfindungsgemäßen Verfahren ist im einzelnen folgendes auszuführen.

Als Preßwerkzeug wird vorzugsweise ein Rahmen verwendet, welcher in seinen lateralen Abmessungen die gewünschte Resistfläche vorgibt und in seiner Höhe die ungefähre Resistdicke. Vorzugsweise wird als Material für den Rahmen ein Metall, z.B. Stahl, verwendet.

Im allgemeinen werden Schichtdicken von 3 bis 2000 $\mu$m benötigt. Besonders bevorzugt sind Schichtdicken von 40 bis 650 $\mu$m.

Der Rahmen kann vorzugsweise einfach auf die Trägerplatte aufgelegt werden oder mit einer Halterung auf der Trägerplatte fixiert werden oder während des Preßvorgangs fest mit der Grundplatte verbunden werden, z.B. durch Anschrauben. Um ein Unterwandern des Polymers während des Preßvorganges zwischen Rahmen und Grundplatte zu vermeiden, ist die Unterseite des Rahmens vorzugsweise poliert oder geläppt und besitzt eine Oberflächenrauhigkeit unter 200 nm.

Der Rahmen kann zusätzlich seitliche Kanäle enthalten, durch die überschüssiges Polymermaterial beim Preßvorgang herausfließen kann.

Die Innenmaße des Rahmens, welche die Resistfläche vorgeben, können je nach Bedarf gewählt werden. Beispielsweise können sie zwischen 20 x 50 mm² bis 125 x 125 mm² betragen.

Als elektrisch leitfähige Träger oder Grundplatten können Metallplatten, z.B. Kupfer, Aluminium, Stahl, beispielsweise mit den Abmessungen 70 bis 150 x 50 bis 150 x 2 bis 15 mm³, vorzugsweise mit den Abmessungen 100 bis 125 x 70 bis 125 x 8 mm³ verwendet werden. Vorzugsweise werden Kupferplatten mit speziell für das jeweils verwendete Polymer adaptierten, elektrisch leitfähigen Haftschichten mit Schichtdicken zwischen 1 und 10 $\mu$m, vorzugsweise zwischen 3,5 und 6 $\mu$m verwendet. Besonders bevorzugt werden elektrisch leitfähige Haftschichten aus oberflächlich oxidiertem Titan verwendet.

Als Polymere können im Prinzip alle bekannten amorphen oder teilkristallinen Thermoplaste verwendet werden, insbesondere amorphe oder teilkristalline Thermoplaste mit Glastemperaturen von 50 bis 200°C, beispielsweise amorphe Thermoplaste mit Erweichungstemperaturen größer 120°C oder teilkristalline Thermoplaste mit Schmelztemperaturen über 120°C.

Bevorzugt eignet sich Polymethylmethacrylat als Granulat mit einem mittleren Molekulargewicht von 100000 bis 400000, sowie teilkristalline Polymere mit Schmelztemperaturen von 140 bis 240°C, wie z.B. Polyoxymethylene, Polyalkensulfone und aliphatische Polyester, wie sie beispielsweise in

DE 41 07 662, DE 41 07 851 und DE 41 41 352 beschrieben sind.

Der Preßvorgang wird beim erfindungsgemäßen Verfahren bei Temperaturen zwischen 100 und 350°C, vorzugsweise bei Temperaturen zwischen 180 und 240°C durchgeführt.

Vor Einwirkung des Druckes wird das Polymer in fester Form in den Rahmen, welcher sich auf der Grundplatte befindet, eingefüllt. Vorzugsweise wird ein Überschuß des Polymers eingesetzt. Der Überschuß ist von der Geometrie des Rahmens, sowie von der Art des eingesetzten Polymers abhängig.

Nach einer Haltezeit von ca. 1 bis 10 Minuten wird innerhalb von ca. 1 bis 10 min mit einem Druck von 20 bis 400 bar auf das Polymer bzw. auf den Rahmen gepreßt. Haltezeit und Druck sind von der Art der eingesetzten Polymeren abhängig.

Die Abkühlzeit auf 20 bis 30°C beträgt im allgemeinen 10 bis 40 min.

Die nach dem oben beschriebenen Verfahren aufgebrachten Polymeren (Resiste) besitzen Schichtdicken bis zu 2000 $\mu$m, vorzugsweise zwischen 40 und 650 $\mu$m. Die Oberflächenrauhigkeit

beträgt unter 200 nm. Nach Überarbeitung der Polymerschicht durch Mikrofräsen kann die Gesamtabweichung der Schichtdicke über die gesamte Resistfläche unter 15 μm eingestellt werden.

Nach der Bestrahlung mit Synchrotronstrahlung durch spezielle Röntgenmasken und der Entwicklung der Polymeren in Form der erfindungsgemäß hergestellten Polymer-Träger-Verbunde erhält man die Mikrostrukturen in der gewünschten Präzision.

Da sich die Polymeren auf einer elektrisch leitfähigen Grundplatte befinden, können anschließend die im LIGA-Verfahren üblichen Folgeschritte Galvanoformung und Abformung durchgeführt werden.

Beispiel

Eine 8 mm dicke Kupferplatte wurde mit ca. 6 μm Titan beschichtet, das oberflächlich mit Wasserstoffperoxid oxidiert wurde. Auf die so vorbehandelte Trägerplatte wurde ein Rahmen mit den Innenmaßen 80,00 x 30,00 mm$^2$ und einer Höhe von 0,350 mm angebracht. In diesen Rahmen wurden 1,260 g Polymethylmethacrylat mit einem mittleren Molekulargewicht $\overline{M}_w = 300.000$ eingefüllt und anschließend in die auf 210°C vorgeheizte Presse gegeben.

Nach einer Haltezeit von 1 min wird 4 min mit einem Druck von 100 bar bei 210°C auf das Polymer bzw. auf den Rahmen gepreßt. Anschließend wird innerhalb von 30 min auf 25°C abgekühlt.

Nach der Entformung beträgt die Schichtdicke des Polymers 350 ± 50 μm. Nach Mikrofräsen beträgt die Schichtdicke des Polymers 350 ± 15 μm. Die Oberflächenrauhigkeit beträgt unter 0,2 μm.

Nach Synchrotronbestrahlung durch eine spezielle Röntgenmaske und nach der Entwicklung mit einem adaptierten Entwickler (GG-Entwickler, siehe DE 3039 110 C2) erhält man Mikrostrukturen aus Polymethylmethacrylat, z.B. Säulen mit einem Durchmesser von 45 μm, welche sich auf einer leitfähigen Schicht aus Titan befinden. Anschließend können die im LIGA-Verfahren üblichen Folgeschritte Galvanoformung und Abformung durchgeführt werden.

**Patentansprüche**

1. Verfahren zur Herstellung von Mikrostrukturkörpern mit Strukturtiefen von mehreren μm bis in den mm-Bereich durch bildmäßiges Bestrahlen von Polymeren mit Röntgenstrahlen und Entfernen der bildmäßig bestrahlten Bereiche der Polymeren, dadurch gekennzeichnet, daß die Polymeren vor dem bildmäßigen Bestrahlen in Schichtdicken von mehreren μm bis in den mm-Bereich durch Aufschmelzen unter Druck auf einen elektrisch leitfähigen Träger aufgebracht und fest verankert werden.

2. Verfahren nach Anspruch 1, dadurch gekennzeichnet, daß als Polymere amorphe Thermoplaste eingesetzt werden, die während des Preßverfahrens aufgeschmolzen werden.

3. Verfahren nach Anspruch 1, dadurch gekennzeichnet, daß als Polymere teilkristalline Thermoplaste eingesetzt werden, die während des Preßverfahrens aufgeschmolzen werden.

4. Verfahren nach einem der vorhergehenden Ansprüche, dadurch gekennzeichnet, daß die Polymeren von einem auf dem elektrisch leitfähigen Träger angebrachten Rahmen umgeben sind.

5. Verfahren nach einem der vorhergehenden Ansprüche, dadurch gekennzeichnet, daß als Röntgenstrahlen zum bildmäßigen Bestrahlen Synchrotronstrahlung eingesetzt wird.

6. Verfahren nach einem der vorhergehenden Ansprüche, dadurch gekennzeichnet, daß Mikrostrukturkörper mit Strukturtiefen zwischen 3 μm und 2000 μm und lateralen Abmessungen von unter 10 μm hergestellt werden.